(19) Europäisches Patentamt

European Patent Office

Office européen des brevets

(11) EP 2 806 565 B1

(12) **FASCICULE DE BREVET EUROPEEN**

(45) Date de publication et mention de la délivrance du brevet:
**27.06.2018 Bulletin 2018/26**

(21) Numéro de dépôt: **14168398.7**

(22) Date de dépôt: **15.05.2014**

(51) Int Cl.:
**H03M 13/29** *(2006.01)* **H03M 13/37** *(2006.01)*

(54) **Procede de decodage d'un code correcteur, par exemple un turbo-code, par analyse du spectre etendu des mots du code**

Decodierverfahren eines Korrekturcodes, beispielsweise eines Turbo-Codes, durch Analyse des ausgedehnten Spektrums der Codewörter

Method for decoding a correction code, for example a turbo-code, by analysing the extended spectrum of the code words

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.05.2013 FR 1301181**

(43) Date de publication de la demande:
**26.11.2014 Bulletin 2014/48**

(73) Titulaires:
- **Thales**
  **92400 Courbevoie (FR)**
- **Centre National d'Etudes Spatiales**
  **75039 Paris Cedex 01 (FR)**

(72) Inventeurs:
- **Gadat, Benjamin**
  **31037 Toulouse Cedex 1 (FR)**
- **Van Wambeke, Nicolas**
  **31037 Toulouse Cedex 1 (FR)**
- **Ries, Lionel**
  **31037 Toulouse Cedex 1 (FR)**

(74) Mandataire: **Hammes, Pierre et al**
**Marks & Clerk France**
**Immeuble Visium**
**22, avenue Aristide Briand**
**94117 Arcueil Cedex (FR)**

(56) Documents cités:
**WO-A1-2011/091845**

- **PAPAGIANNIS E ET AL: "Approaching the ML performance with iterative decoding", COMMUNICATIONS, 2004 INTERNATIONAL ZURICH SEMINAR ON ZURICH, SWITZERLAND FEB.18-20, 2004, PISCATAWAY, NJ, USA,IEEE, 18 février 2004 (2004-02-18), pages 220-223, XP010697709, DOI: 10.1109/IZS.2004.1287429 ISBN: 978-0-7803-8329-6**
- **Youssouf Ould-Cheikh-Mouhamedou1 ET AL: "A Method for Lowering Turbo Code Error Flare using Correction Impulses and Repeated Decoding", 6th International ITG-Conference on Source and Channel Coding (TURBOCODING), 3 avril 2006 (2006-04-03), XP055095610, Extrait de l'Internet: URL:http://ieeexplore.ieee.org/ielx5/57555 87/5755588/05755908.pdf?tp=&arnumber=57559 08&isnumber=5755588 [extrait le 2014-01-09]**
- **ÖBERG M ET AL: "Application of Distance Spectrum Analysis to Turbo Code Performance Improvement", INTERNATIONAL SYMPOSIUM ON TURBO CODES AND RELATED TOPICS, XX, XX, 3 septembre 1997 (1997-09-03), pages 1-10, XP002251688,**
- **JINGYU KANG ET AL: "An Iterative Decoding Algorithm with Backtracking to Lower the Error-Floors of LDPC Codes", IEEE TRANSACTIONS ON COMMUNICATIONS, IEEE SERVICE CENTER, PISCATAWAY, NJ. USA, vol. 59, no. 1, 1 janvier 2011 (2011-01-01), pages 64-73, XP011341754, ISSN: 0090-6778, DOI: 10.1109/TCOMM.2010.101210.090628**

**(Cont. page suivante)**

- BERROU C ET AL: "Computing the minimum distance of linear codes by the error impulse method", GLOBECOM'02. 2002 - IEEE GLOBAL TELECOMMUNICATIONS CONFERENCE. CONFERENCE PROCEEDINGS. TAIPEI, TAIWAN, NOV. 17 - 21, 2002; [IEEE GLOBAL TELECOMMUNICATIONS CONFERENCE], NEW YORK, NY : IEEE, US, vol. 2, 17 novembre 2002 (2002-11-17), pages 1017-1020, XP010636299, DOI: 10.1109/GLOCOM.2002.1188348 ISBN: 978-0-7803-7632-8

**Description**

L'invention concerne un procédé de décodage d'un code correcteur par analyse du spectre des mots du code et s'applique avantageusement à un code correcteur de la famille des turbo-codes.

Les algorithmes connus de décodage des codes correcteurs de la famille des turbo-codes présentent des limitations du point de vue des performances de taux d'erreurs bits après décodage à fort rapport signal à bruit. En effet, il est connu qu'au delà d'une valeur seuil de rapport signal à bruit, le taux d'erreurs bits après décodage d'un turbo-code ne peut pas être amélioré avec un algorithme de décodage usuel. Ce phénomène est connu sous l'appellation « plancher d'erreur » ou « error-floor » en anglais qui caractérise le niveau minimal du taux d'erreurs bits en dessous duquel il n'est pas possible d'améliorer les performances.

Ce phénomène, bien connu du domaine, est lié au fait que certains mots de code présentent une distance minimum, c'est-à-dire une distance vis-à-vis du mot de code le plus proche, faible. Or la distance minimum a un impact direct sur le pouvoir de correction du code. Si un mot de code reçu se situe à une distance inférieure à la distance minimum du mot de code émis, alors le décodeur converge à coup sur vers le bon mot de code. Au contraire, plus le mot de code reçu se situe à une distance importante du mot de code émis, plus la convergence du décodeur est difficile.

Plusieurs méthodes sont connues pour résoudre le problème du plancher d'erreur des codes correcteurs de la famille des turbo-codes.

Une première solution consiste à ajouter un code externe, par exemple un code BCH ou un code Reed-Solomon pour former un schéma concaténé. Cette technique permet d'améliorer les performances de décodage en éliminant le phénomène de plancher d'erreur mais présente le défaut de diminuer l'efficacité spectrale ou le débit utile de la transmission. En effet, le rendement global des deux codes concaténés est inférieur au rendement seul du turbo-code.

Une deuxième solution, proposée dans la publication [1], consiste à analyser le spectre des mots du code afin d'identifier les bits les moins protégés dans la trame du code. En effet il est connu que sur ces codes, tous les bits ne sont pas protégés de manière équitable. Donc l'impact d'une erreur sur un bit donné n'est pas le même que celui d'une erreur sur le bit voisin. Une fois l'ensemble $\Omega$ de ces bits déterminé, un turbo codeur insère aux positions signifiées par l'ensemble $\Omega$ des bits connus. En conséquence, lors du décodage, l'ensemble $\Omega$ ainsi que les valeurs des bits insérés étant connus, une fiabilité importante est déclarée à l'entré du turbo-décodeur afin d'en améliorer les performances. Les bits insérés sont ensuite retirés à la sortie du turbo-décodeur afin de retrouver la trame d'information.

Cette solution présente également le défaut de diminuer le rendement effectif du code puisque des bits sont ajoutés par le codeur ce qui diminue le nombre de bits utiles pour une taille de trame d'information donnée.

Une troisième solution, proposée dans le document [2] consiste à introduire des impulsions à des positions données dans la trame. Ces positions sont déterminées en se basant sur les informations de vraisemblance des bits à l'entrée du décodeur. Ces informations sont triées en fonction de leur magnitude uniquement et les impulsions sont introduites une a une en commençant par les vraisemblances les moins fiables.

Cette solution à pour défaut d'être très complexe. En effet, elle apparaît efficace uniquement pour un grand nombre de positions et repose sur le principe que tous les bits dans la trame ont la même importance, ce qui n'est pas vrai pour un turbo-code.

Une autre solution est proposée dans la publication [7].

L'invention propose un procédé de décodage amélioré permettant de résoudre le problème du plancher d'erreur d'un turbo-code ou d'un code LDPC, ou plus généralement d'un code correcteur de la famille des « turbolike codes », tout en conservant la même efficacité spectrale c'est-à-dire sans diminution du débit utile du flux encodé. Ce résultat est obtenu par une identification, en entrée du décodeur, des bits sur lesquels une erreur a un impact fort, et une modification des vraisemblances correspondants à ces bits afin d'améliorer la convergence du décodeur.

L'invention a pour objet un procédé itératif de décodage d'un mot de code reçu d'un code correcteur, ledit mot de code étant représenté par une information de vraisemblance locale de chaque bit dont il est constitué, ledit procédé itératif étant caractérisé en ce qu'il comporte les étapes suivantes :

- Une étape d'analyse du spectre étendu des mots du code comprenant les sous-étapes suivantes :

  • Sélectionner un mot de code,
  • Pour chaque bit dudit mot de code, exécuter de façon itérative les étapes suivantes :

    > Modifier la valeur dudit bit,
    > Décoder le mot de code modifié,
    > Encoder le résultat du décodage,
    > Calculer une distance entre le résultat de l'encodage et le mot de code modifié,
    > Sauvegarder la distance calculée dans une table,

- L'exécution de façon itérative des étapes suivantes :

  • Une étape de décodage dudit mot de code reçu,
  • Une étape de test d'arrêt du procédé,
  • Une étape de calcul d'une information de vraisemblance globale IM(i) du mot de code décodé,
  • Une étape de comparaison, à partir de la deuxième itération (i=2), de l'information de vraisemblance globale IM(i) calculée à l'itération courante (i) avec l'information de vraisemblance globale IM(i-1) calculée à l'itération précédente (i-1),

- Une étape de modification de l'amplitude et du signe de l'information de vraisemblance locale LLR d'un bit dudit mot de code reçu, l'indice du bit sélectionné correspondant à l'indice de ladite table associé à la distance la plus faible dans la table, parmi les indices non sélectionnés à une itération précédente,

- A partir de la deuxième itération (i= 2), si l'information de vraisemblance globale IM(i) calculée à l'itération courante (i) est inférieure à l'information de vraisemblance globale IM(i-1) calculée à l'itération précédente (i-1), une étape de réinitialisation de l'information de vraisemblance locale du bit dudit mot de code reçu modifiée à l'itération précédente.

Lorsque l'étape de décodage est itérative, le test d'arrêt peut être un test sur le nombre d'itérations de l'étape de décodage.

Le test d'arrêt peut aussi être un test de convergence de l'étape de décodage.

Le test de convergence comprend, par exemple, la détection d'une erreur dans le résultat de l'étape de décodage par application d'un code détecteur d'erreurs (CRC).

Le test de convergence comprend, par exemple, la comparaison de l'information de vraisemblance globale IM(i) à une valeur seuil prédéterminée.

L'information de vraisemblance globale IM(i) est, par exemple, une information mutuelle ou est égale à l'inverse de la distance Euclidienne entre le mot de code décodé puis ré-encodé et le mot de code reçu.

Selon un aspect particulier de l'invention, ledit sous ensemble des bits du mot de code reçu est égal à l'intégralité des bits du mot de code reçu ou à un sous-ensemble constitué des bits dont la vraisemblance locale LLR présente une valeur absolue inférieure à un seuil prédéterminé.

Selon un aspect particulier de l'invention, le code correcteur est un turbo-code ou un code LDPC.

L'invention a également pour objet un programme d'ordinateur comportant des instructions pour l'exécution du procédé itératif de décodage selon l'invention, lorsque le programme est exécuté par un processeur, un support d'enregistrement lisible par un processeur sur lequel est enregistré un programme comportant des instructions pour l'exécution du procédé itératif de décodage selon l'invention, lorsque le programme est exécuté par un processeur et un dispositif comprenant des moyens adaptés pour exécuter les étapes du procédé selon l'invention.

D'autres caractéristiques et avantages de la présente invention apparaîtront mieux à la lecture de la description qui suit en relation aux dessins annexés qui représentent:

- La figure 1, un diagramme des performances théoriques d'un code correcteur de la famille des turbo-codes, en taux d'erreur fonction du rapport signal à bruit, illustrant les limitations des méthodes de décodage usuelles,

- La figure 2, un schéma illustrant la notion de distance minimum d'un code correcteur,

- La figure 3, un organigramme illustrant les étapes de mise en oeuvre du procédé de décodage selon l'invention,

- La figure 4, un organigramme détaillant, dans un exemple de réalisation, les sous- étapes de mise en oeuvre de l'étape d'analyse du spectre étendu des mots de code,

L'invention vise notamment à améliorer les performances des procédés de décodage usuels des turbo-codes ou de codes correcteurs de la même famille.

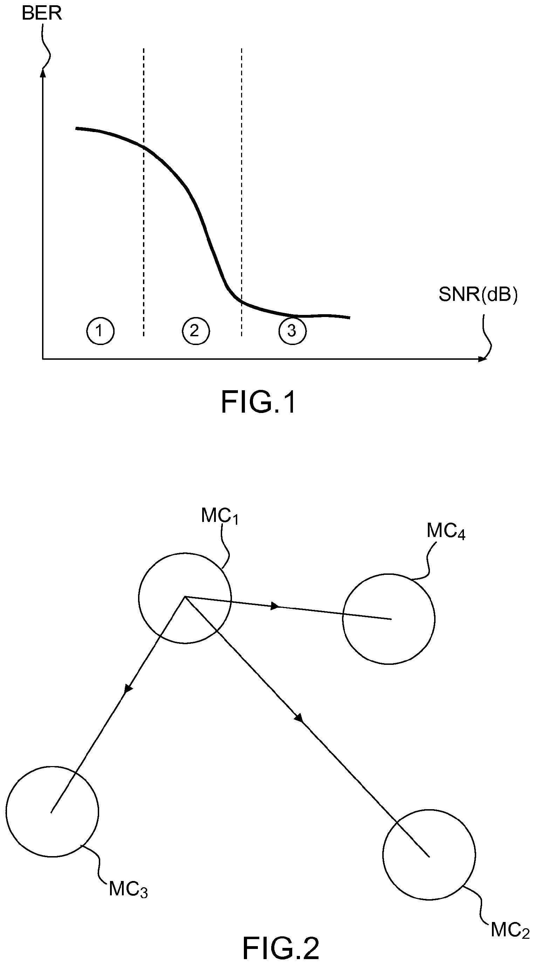

La figure 1 représente un diagramme des performances théoriques d'un code correcteur de la famille des turbo-codes. L'abscisse SNR correspond au rapport signal à bruit exprimé en décibels et l'ordonnée BER correspond au taux d'erreurs bits.

La courbe de taux d'erreurs bits caractéristique d'un turbo-code comporte, comme cela est bien connu du domaine, trois zones 1,2,3 qui peuvent être distinguées en fonction du rapport signal à bruit. La première zone 1 est une zone où le taux d'erreurs bits sature à une valeur maximale du fait d'un rapport signal à bruit trop faible. La deuxième zone 2 est une zone où le taux d'erreurs bits diminue rapidement avec l'augmentation du rapport signal à bruit. La troisième zone 3 est une zone dite « plancher » qui correspond à un rapport signal à bruit maximum au delà duquel le décodeur atteint une limite en taux d'erreurs bits en dessous de laquelle il ne parvient plus à améliorer le décodage.

Un objectif de l'invention est de résoudre l'effet de la zone « plancher » d'un turbo-code sans impacter l'efficacité spectrale.

Le problème de la zone plancher à fort rapport signal à bruit est intrinsèquement lié aux mots de codes de poids faible, c'est-à-dire aux mots de code se trouvant à une distance d faible d'un autre mot de code.

La figure 2 illustre la notion de distance entre plusieurs mots de code. Sur l'exemple de la figure 2, le mot de code MC1 est de poids plus faible que le mot de code MC2 car sa distance minimale, c'est-à-dire la plus petite distance à un autre mot de code, est plus faible que celle du mot de code MC2.

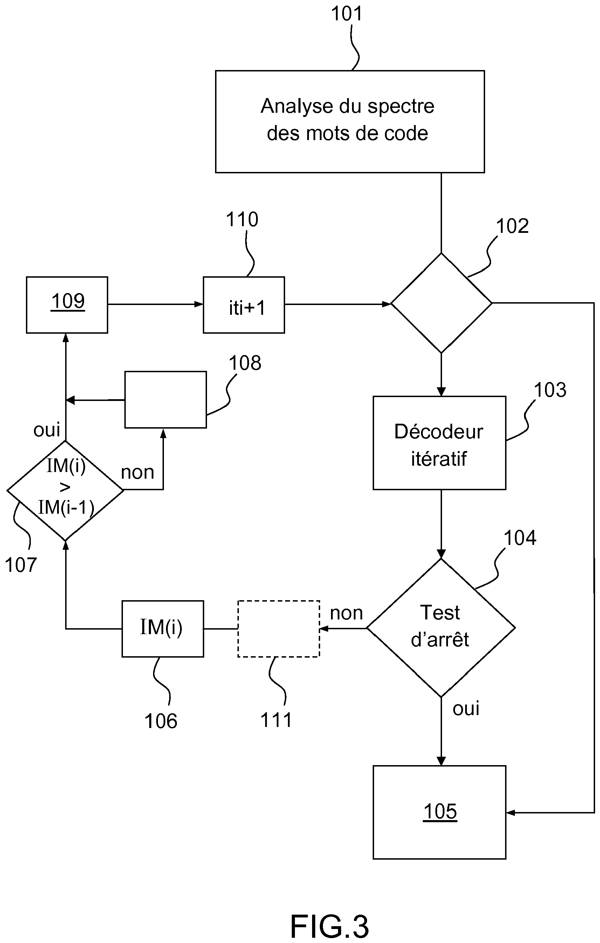

La figure 3 illustre, sur un organigramme, les étapes de mise en oeuvre du procédé de décodage selon l'invention.

Le procédé selon l'invention consiste à réaliser le décodage d'au moins un mot de code par un code correcteur de la famille des turbo-codes. L'invention s'applique également aux codes LDPC (Low Density Parity Check) ou à tout code dit de la famille des « turbo like codes », autrement dit des codes correcteurs construits à partir de graphes et qui sont décodés de façon itérative.

Un mot de code est défini par un premier vecteur de taille N contenant les bits ou symboles reçus et un second vecteur, noté par la suite LLR, de même taille N, contenant une information sur la fiabilité ou la vraisemblance des bits ou symboles reçus. Par exemple, cette information peut être définie par un rapport de vraisemblance ou « log-likelihood ratio » en anglais qui constitue une information souple (c'est-à-dire non binaire) donnant une indication sur la fiabilité du bit reçu. Par exemple, plus la magnitude d'une valeur LLR est élevée, plus la probabilité qu'il n'y ait pas d'erreur sur le bit correspondant est élevée. Le signe de la valeur LLR défini le bit correspondant (O ou 1) selon la constellation de la modulation choisie.

Un mot de code en entrée du procédé de décodage selon l'invention peut avoir été soumis à des perturbations, par exemple liées aux imperfections du canal de transmission, qui entrainent des erreurs sur les bits reçus et sur les informations de vraisemblance LLR.

Un objectif de l'invention est d'améliorer le taux d'erreurs après décodage par rapport aux méthodes de décodage usuelles.

La première étape 101 du procédé est une étape préalable au décodage et peut être exécutée séparément du décodage lui-même. Elle consiste à réaliser une analyse du spectre étendu des mots du code correcteur.

L'analyse du spectre d'un code correcteur consiste à déterminer la répartition des mots du code en fonction de leur distance à un autre mot de code. La distance minimum d'un mot de code est la plus petite distance entre ce mot de code et les autres mots de code de l'alphabet du code correcteur considéré. La distance la plus couramment utilisée est la distance de Hamming, autrement dit le nombre de bits différents entre deux mots de code.

Différentes techniques sont connues pour réaliser une analyse du spectre d'un code correcteur parmi lesquelles celles décrites dans les publications [3],[4] et [5].

La première étape 101 du procédé consiste à déterminer le spectre étendu du code correcteur. Plus précisément, il s'agit, pour chaque mot de code, d'imposer un des bits du mot à une valeur erronée et de calculer la distance entre ce mot de code et le même mot de code modifié décodé puis recodé.

Autrement dit, pour un mot de code de taille N, l'analyse du spectre étendu conduit à générer N distances, chacune correspondant au même mot de code mais dans lequel un des bits est erroné. La distance est calculée après décodage du mot de code dont un bit est volontairement forcé à une valeur incorrecte en calculant la distance de Hamming entre le mot décodé obtenu puis recodé et le mot de code initial.

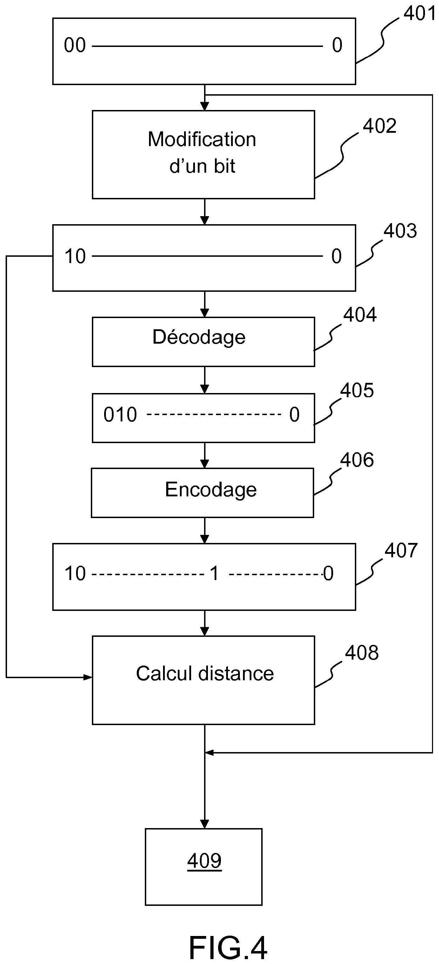

La figure 4 détaille, selon un exemple de réalisation, les sous-étapes de l'étape 101 d'analyse du spectre étendu des mots de code.

L'organigramme de la figure 4 schématise les sous-étapes nécessaires pour l'analyse du spectre étendu pour un mot de code donné. Les étapes représentées doivent être réitérées pour l'ensemble des mots de code ou un sous-ensemble de cet ensemble.

Les sous-étapes de l'étape 101 comportent notamment une première étape de sélection d'un mot de code 401. Avantageusement, le mot de code 401 choisi est le mot de code comportant tous ses bits à 0. Mais le mot de code 401 choisi peut être n'importe lequel des mots du code. L'analyse du spectre étendu peut n'être effectuée que pour cet unique mot de code 401 car le code correcteur utilisé est un code linéaire et par conséquent les propriétés des mots de code sont identiques et transposables d'un mot de code vers un autre. Il est donc inutile d'appliquer les étapes décrites à la figure 4 pour plusieurs mots de code 401 différents.

Le mot de code 401 subit ensuite une modification 402 de l'un de ses bits, autrement dit la valeur de ce bit est inversée.

Le mot de code modifié 403 est ensuite décodé 404 en utilisant préférentiellement le même décodeur que celui utilisé par le procédé de décodage selon l'invention. On obtient ainsi un mot décodé 405 qui est ensuite à nouveau encodé 406 pour obtenir un nouveau mot de code 407. Ce nouveau mot de code 407 est ensuite comparé avec le mot de code initial 401 en calculant une distance de Hamming 408 entre les deux mots de code qui est stockée dans un fichier 409 ou une mémoire.

Les étapes 402 à 408 sont réitérées en modifiant un à un chacun des bits du mot de code 401 pour obtenir au final un tableau 409 indiquant pour chaque indice de bit, la distance de Hamming entre le mot de code obtenu lorsque le bit correspondant est erroné et le mot de code correct. Cette distance de Hamming est une information sur l'impact d'une erreur sur un mot de code en fonction du bit erroné.

Dans une variante de réalisation, afin de limiter le temps de calcul nécessaire, l'analyse du spectre étendu est réalisée sur un sous-ensemble des bits du mot de code 401, en recherchant uniquement les bits sur lesquels une erreur entraine un mot décodé 407 distant du mot d'origine 401 d'une distance seuil prédéterminée.

La mise en oeuvre de l'étape 101 d'analyse du spectre étendu peut être réalisée une fois pour toutes en utilisant le même algorithme de décodage itératif que celui utilisé pour réaliser le décodage selon l'invention.

L'étape 101 aboutit à la génération d'une table 409, qui peut être stockée, par exemple dans un fichier ou une base de données, contenant, pour chaque indice de bit d'un mot de code, une distance associée.

On poursuit à présent la description des étapes du procédé de décodage selon l'invention tel qu'illustré à la figure 3.

Le procédé de décodage selon l'invention est un procédé itératif qui reçoit en entrée un vecteur des bits reçus et un vecteur associé contenant les informations de vraisemblance des bits reçus et produit en sortie un vecteur décodé et un vecteur associé contenant également les informations de vraisemblance des bits décodés.

Dans une première itération, un décodage 103 usuel est appliqué, par exemple un décodage itératif.

Dans une étape 104, un test d'arrêt est réalisé pour arrêter le décodage 103 lorsque celui-ci a convergé ou avant convergence pour limiter la complexité.

Ce test d'arrêt peut être réalisé via au moins l'une des méthodes suivantes ou en utilisant plusieurs de ces méthodes prises en combinaison.

Un premier test d'arrêt consiste à utiliser un code détecteur d'erreurs du type CRC (Cyclic Redundancy Check) pour protéger les données avant codage. Un test de détection est effectué après décodage 103 pour vérifier si le mot de code obtenu est correct. Le décodage 103 est itéré tant que le décodage du CRC n'est pas positif afin de tester la convergence du décodeur.

Un deuxième test d'arrêt consiste à fixer un critère d'arrêt au décodeur 103 en fonction du nombre d'itérations, autrement dit à fixer un nombre d'itérations maximum au delà duquel le décodage 103 est arrêté.

Un troisième test d'arrêt consiste à calculer un critère de vraisemblance globale en sortie de décodage 103 et à comparer ce critère à un seuil. Un critère de vraisemblance globale est une indication de la fiabilité du décodage sur un mot de code. Par exemple, il peut s'agit d'une valeur comprise entre 0 et 1, la valeur 0 correspondant à un décodage totalement erroné (avec un taux d'erreur de 50%) et la valeur 1 correspondant à un décodage correct (avec un taux d'erreur de 0%). Un exemple de calcul de vraisemblance globale consiste à calculer un critère d'information mutuelle tel que décrit dans la publication [6]. Le troisième test d'arrêt peut consister à arrêter le décodage 103 lorsque le critère de vraisemblance globale est supérieur à une valeur seuil, par exemple une valeur égale à 0,9.

De façon générale, d'autres tests d'arrêt sont possibles, notamment basés sur une détection de la convergence du décodage 103, c'est-à-dire l'arrêt de l'évolution du décodage, de sorte à arrêter le décodage lorsqu'il n'évolue plus dans sa décision.

Si le test de convergence 104 est positif, autrement dit si le décodage 103 a convergé vers une décision, cette décision est considérée comme la décision finale 105, elle est constituée du vecteur binaire décodé et d'un second vecteur contenant une information de vraisemblance locale de chaque bit décodé.

La production d'informations de vraisemblances locales en sortie de décodage nécessite l'utilisation d'un décodeur apte à recevoir en entrée des informations souples (par opposition à des informations binaires) et à générer en sortie des informations souples, un tel décodeur est connu dans le domaine des codes correcteurs sous l'appellation décodeur SISO (Soft Input Soft Output).

Si le test d'arrêt 104 est négatif, par exemple si le décodage 103 n'a pas convergé vers une décision stable, alors une nouvelle itération du procédé selon l'invention est déclenchée.

Dans une étape 106, on calcule un critère de vraisemblance globale IM(i) à partir du vecteur des informations de vraisemblances locales des bits décodés. Ce critère peut être une information mutuelle comme indiquée dans la publication [6] ou peut être calculé par d'autres moyens équivalents. En particulier le critère de vraisemblance globale peut également être égal à l'inverse d'un calcul de distance Euclidienne entre le vecteur décodé puis recodé et le vecteur en entrée du procédé de décodage. Par exemple, ce calcul de distance Euclidienne peut être réalisé à l'aide de la relation suivante:

$$D = \sum_{i=0}^{N-1} \sqrt{(R_i - X_i)},$$ avec N la taille du mot de code, $R_i$ les vraisemblances locales associées aux bits du mot de code produit en entrée du décodage itératif 103 et $X_i$ les bits du mot de code obtenu en ré-encodant le vecteur obtenu en sortie du décodage itératif 103.

Dans une étape de test 107, on compare le critère de vraisemblance globale IM(i) calculé pour l'itération courante i au critère de vraisemblance globale IM(i-1) calculé pour l'itération précédente i-1. Bien entendu, ce test n'est appliqué qu'à partir de la seconde itération (i=2).

Si le critère de vraisemblance globale IM(i) calculé pour l'itération courante est supérieur au critère de vraisemblance globale IM(i-1) calculé pour l'itération précédente i-1 ou si l'itération est la première (i=1) alors une étape 109 de modification du vecteur d'entrée des informations de vraisemblances locales est opérée.

Selon cette étape de modification 109, un indice du vecteur d'entrée est sélectionné et la valeur correspondante à cet indice est modifiée par une valeur de signe opposée à la valeur initiale et d'amplitude au moins égale à la distance minimum du code correcteur considéré.

Pour déterminer l'indice à sélectionner, on recherche, dans la table 409 générée à l'issue de l'étape d'analyse de spectre étendu 101, l'indice correspondant à la distance de Hamming la plus faible. Cet indice correspond au bit qui si il est erroné sera le plus difficile à corriger pour le décodeur. En effet, dans la zone de plancher d'erreurs, on peut remarquer que les erreurs commises par un décodeur itératif sont souvent dues à des mots de codes dits de poids faible, autrement dit des mots de codes qui comportent peu de bits différents par rapport au mot de code original. En modifiant la valeur des bits (à l'aide d'une impulsion) qui sont naturellement les moins protégés par la structure même du code, il est ainsi possible de parvenir à contourner le phénomène de plancher d'erreurs.

Si cet indice a déjà été utilisé lors d'une itération précédente du procédé il n'est plus éligible, l'indice sélectionné est alors celui qui est associé à la distance la plus faible, parmi les indices encore éligibles.

Si le critère de vraisemblance globale IM(i) calculé pour l'itération courante est inférieur ou égal au critère de vraisemblance globale IM(i-1) calculé pour l'itération précédente i-1 et si l'itération est différente de la première (i≠1), alors, dans une étape 108 supplémentaire, la valeur modifiée dans le vecteur d'entrée à l'étape précédente i-1 est réinitialisée à sa valeur d'origine.

Les étapes 106,107,108,109 sont itérées 110 et un test 102 est appliqué pour vérifier que la totalité des valeurs du vecteur d'entrée ont été modifiées par l'étape 109 auquel cas le procédé de décodage est finalisé avec la décision 105 obtenue lors de la dernière itération.

Dans une variante de réalisation de l'invention, une étape 111 supplémentaire est exécutée lorsque le test d'arrêt 104 est négatif et en préalable à l'étape 106 de calcul de vraisemblance globale. Cette étape 111 supplémentaire consiste à sélectionner un sous-ensemble des valeurs du vecteur LLR d'entrée du décodeur, ce sous-ensemble étant constitué des valeurs de vraisemblances locales les plus faibles, qui correspondent aux bits les plus susceptibles d'être erronés.

Les itérations sur les indices du vecteur LLR d'entrée sont ensuite opérées uniquement sur ce sous-ensemble, dans l'optique de limiter la complexité de l'algorithme ainsi que son temps d'exécution.

Le procédé de décodage selon l'invention peut être implémenté à partir d'éléments matériel et/ou logiciel. Il peut notamment être mis en oeuvre en tant que programme d'ordinateur comportant des instructions pour son exécution. Le programme d'ordinateur peut être enregistré sur un support d'enregistrement lisible par un processeur.

Il peut être utilisé dans un contexte de transmission d'un flux de données codées entre un émetteur et un récepteur, le procédé selon l'invention étant implémenté dans le récepteur.

Il peut également être exécuté à partir d'un flux de données codées et stockées dans un dispositif de stockage.

Les différentes étapes du procédé selon l'invention peuvent également être exécutées par un dispositif comprenant un processeur et une mémoire. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gâte Array »).

### Références

[1] M. Oberg & P. Siegel, « Application of distance spectrum analysis to turbo code performance improvement », Proc. 35th Annu. Conf. Commun, Control and Computing. pp 701-710, Sept 1997.
[2] Y. Ould-Cheikh-Mouhamedou, "A Method for Lowering Turbo Code Error Flare using Correction Impulses and Repeated Decoding", 6th international ITG-Conference on Source and Channel Coding (Turbocoding), 2006
[3] C. Berrou and S. Vaton, Computing the minimum distance of linear codes by the error impulse method, proc. of IEEE ISIT, 2002
[4] S. Crozier et al, Estimating the Minimum Distance of Turbo-Codes using double and Triple Impulse Methods, IEEE Comm. Letters, 2005
[5] R. Garello and A. Vila, The All-zero iterative decoding algorithm for turbo code minimum distance computation, in proc of IEEE ICC, 2004.
[6] J. Hagenauer, The Exit Chart - Introduction to Extrinsic Information Transfer in iterative Processing, in Proc. of 12th Europ. Signal. Proc. (EUSIPCO), 2004.
[7] E. Papagiannis et al, Approaching the ML performance with iterative decoding, Int. Zurich Seminar on Communications, 18 février 2004.

### Revendications

1. Procédé itératif de décodage d'un mot de code reçu d'un code correcteur, ledit mot de code étant représenté par une information de vraisemblance locale (LLR) de chaque bit dont il est constitué, ledit procédé itératif étant **caractérisé en ce qu'**il comporte les étapes suivantes :

   - Une étape (101) d'analyse du spectre étendu des mots du code comprenant les sous-étapes suivantes :

      • Sélectionner (401) un mot de code,
      • Pour chaque bit dudit mot de code, exécuter de façon itérative les étapes suivantes :

         ➢ Modifier (402) la valeur dudit bit,

         ➢ Décoder (404) le mot de code modifié (403),

         ➢ Encoder (405) le résultat du décodage (404),

         ➢ Calculer une distance entre le résultat de l'encodage (405) et le mot de code modifié (403),

         ➢ Sauvegarder la distance calculée dans une table (409),

   - L'exécution (102) de façon itérative des étapes suivantes :

    • Une étape (103) de décodage dudit mot de code reçu,
    • Une étape de test d'arrêt (104) du procédé,
    • Une étape (106) de calcul d'une information de vraisemblance globale IM(i) du mot de code décodé,
    • Une étape (107) de comparaison, à partir de la deuxième itération (i=2), de l'information de vraisemblance globale IM(i) calculée à l'itération courante (i) avec l'information de vraisemblance globale IM(i-1) calculée à l'itération précédente (i-1),
    • Une étape (109) de modification de l'amplitude et du signe de l'information de vraisemblance locale LLR d'un bit dudit mot de code reçu, l'indice du bit sélectionné correspondant à l'indice de ladite table (409) associé à la distance la plus faible dans la table, parmi les indices non sélectionnés à une itération précédente,
    • A partir de la deuxième itération (i=2), si l'information de vraisemblance globale IM(i) calculée à l'itération courante (i) est inférieure à l'information de vraisemblance globale IM(i-1) calculée à l'itération précédente (i-1), une étape (108) de réinitialisation de l'information de vraisemblance locale du bit dudit mot de code reçu modifiée à l'itération précédente.

2. Procédé itératif de décodage selon la revendication 1 dans lequel ladite étape (103) de décodage est itérative et le test d'arrêt (104) est un test sur le nombre d'itérations de l'étape (103) de décodage.

3. Procédé itératif de décodage selon la revendication 1 dans lequel le test d'arrêt (104) est un test de convergence de l'étape (103) de décodage.

4. Procédé itératif de décodage selon la revendication 3 dans lequel le test de convergence comprend la détection d'une erreur dans le résultat de l'étape (103) de décodage par application d'un code détecteur d'erreurs (CRC).

5. Procédé itératif de décodage selon la revendication 3 dans lequel le test de convergence comprend la comparaison de l'information de vraisemblance globale IM(i) à une valeur seuil prédéterminée.

6. Procédé itératif de décodage selon l'une des revendications précédentes dans lequel l'information de vraisemblance globale IM(i) est une information mutuelle.

7. Procédé itératif de décodage selon l'une des revendications 1 à 5 dans lequel l'information de vraisemblance globale IM(i) est égale à l'inverse de la distance Euclidienne entre le mot de code décodé puis ré-encodé et le mot de code reçu.

8. Procédé itératif de décodage selon l'une des revendications précédentes dans lequel ledit sous ensemble des bits du mot de code reçu est égal à l'intégralité des bits du mot de code reçu ou à un sous-ensemble constitué des bits dont la vraisemblance locale LLR présente une valeur absolue inférieure à un seuil prédéterminé.

9. Procédé itératif de décodage selon l'une des revendications précédentes dans lequel le code correcteur est un turbo-code ou un code LDPC.

10. Programme d'ordinateur comportant des instructions pour l'exécution du procédé itératif de décodage selon l'une quelconque des revendications 1 à 9, lorsque le programme est exécuté par un processeur.

11. Support d'enregistrement lisible par un processeur sur lequel est enregistré un programme comportant des instructions pour l'exécution du procédé itératif de décodage selon l'une quelconque des revendications 1 à 9, lorsque le programme est exécuté par un processeur.

12. Dispositif comprenant des moyens adaptés pour exécuter les étapes du procédé selon l'une des revendications 1 à 9.

**Patentansprüche**

1. Iteratives Verfahren zum Decodieren eines von einem Korrekturcode empfangenen Code-Worts, wobei das Code-Wort durch eine lokale Wahrscheinlichkeitsinformation (LLR) jedes Bits repräsentiert wird, von dem es gebildet ist, wobei das iterative Verfahren **dadurch gekennzeichnet ist, dass** es die folgenden Schritte beinhaltet:

    - einen Schritt (101) des Analysierens des erweiterten Spektrums von Wörtern des Codes, der die folgenden Unterschritte beinhaltet:

        • Auswählen (401) eines Code-Worts,
        • Ausführen, für jedes Bit des Code-Worts, der folgenden Schritte auf iterative Weise:

            ➢ Modifizieren (402) des Wertes des Bits,

            ➢ Decodieren (404) des modifizierten Code-Worts (403),

➢ Encodieren (405) des Ergebnisses der Decodierung (404),

➢ Berechnen einer Distanz zwischen dem Ergebnis der Encodierung (405) und dem modifizierten Code-Wort (403),

➢ Sichern der berechneten Distanz in einer Tabelle (409),

- Ausführen (102), auf iterative Weise, der folgenden Schritte:

• einen Schritt (103) des Decodierens des empfangenen Code-Worts,
• einen Schritt des Stopptestens (104) des Verfahrens,
• einen Schritt (106) des Berechnens einer globalen Wahrscheinlichkeitsinformation IM(i) des decodierten Code-Worts,
• einen Schritt (107) des Vergleichens, auf der Basis der zweiten Iteration (i=2), der in der laufenden Iteration (i) berechneten globalen Wahrscheinlichkeitsinformation IM(i) mit der in der vorherigen Iteration (i-1) berechneten globalen Wahrscheinlichkeitsinformation IM(i-1),
• einen Schritt (109) des Modifizierens der Amplitude und des Vorzeichens der lokalen Wahrscheinlichkeitsinformation LLR eines Bits des empfangenen Codeworts, wobei der Index des gewählten Bits dem Index der mit der geringsten Distanz in der Tabelle assoziierten Tabelle (409) unter den bei der vorherigen Iteration nicht gewählten Indexen entspricht,
• einen Schritt (108) des Neuinitialisierens der lokalen Wahrscheinlichkeitsinformation des Bits des bei der vorherigen Iteration modifizierten empfangenen Code-Worts auf der Basis der zweiten Iteration (i=2), wenn die in der laufenden Iteration (i) berechnete globale Wahrscheinlichkeitsinformation IM(i) kleiner ist als die in der vorherigen Iteration (i-1) berechnete globale Wahrscheinlichkeitsinformation IM(i-1).

2. Iteratives Decodierverfahren nach Anspruch 1, bei dem der Schritt (103) des Decodierens iterativ ist und der Stopptest (104) ein Test in Bezug auf die Anzahl von Iterationen des Decodierschritts (103) ist.

3. Iteratives Decodierverfahren nach Anspruch 1, bei dem der Stopptest (104) ein Konvergenztest des Decodierschritts (103) ist.

4. Iteratives Decodierverfahren nach Anspruch 3, bei dem der Konvergenztest das Erkennen eines Fehlers im Ergebnis des Decodierungsschritts (103) durch Anwenden eines Fehlererkennungscode (CRC) beinhaltet.

5. Iteratives Decodierverfahren nach Anspruch 3, bei dem der Konvergenztest das Vergleichen der globalen Wahrscheinlichkeitsinformation IM(i) mit einem vorbestimmten Schwellenwert beinhaltet.

6. Iteratives Decodierverfahren nach einem der vorherigen Ansprüche, bei dem die globale Wahrscheinlichkeitsinformation IM(i) eine gegenseitige Information ist.

7. Iteratives Decodierverfahren nach einem der Ansprüche 1 bis 5, bei dem die globale Wahrscheinlichkeitsinformation IM(i) gleich der Umkehr der euklidischen Distanz zwischen dem decodierten und dann neucodierten Code-Wort und dem empfangenen Code-Wort ist.

8. Iteratives Decodierverfahren nach einem der vorherigen Ansprüche, bei dem der Teilsatz von Bits des empfangenen Code-Worts gleich der Integralität der Bits des empfangenen Code-Worts oder gleich einem Teilsatz ist, der von Bits gebildet wird, deren lokale Wahrscheinlichkeit LLR einen absoluten Wert aufweist, der kleiner ist als eine vorbestimmte Schwelle.

9. Iteratives Decodierverfahren nach einem der vorherigen Ansprüche, bei dem der Korrekturcode ein Turbo-Code oder ein LDPC-Code ist.

10. Computerprogramm, das Befehle zum Ausführen des iterativen Decodierverfahrens nach einem der Ansprüche 1 bis 9 umfasst, wenn das Programm von einem Prozessor ausgeführt wird.

11. Aufzeichnungsmedium, das für einen Prozessor lesbar ist und auf dem ein Programm aufgezeichnet ist, das Befehle zum Ausführen des iterativen Decodierverfahrens nach einem der Ansprüche 1 bis 9 umfasst, wenn das Programm von einem Prozessor ausgeführt wird.

12. Vorrichtung, die Mittel zum Ausführen der Schritte des Verfahrens nach einem der Ansprüche 1 bis 9 umfasst.

**Claims**

1. Iterative method for decoding a code word received from a correction code, said code word being represented by information of local likelihood (LLR) of each bit of which it is constituted, said iterative method being **characterised in that** it comprises the following steps:

- A step (101) of analysing the extended spectrum of the code words comprising the following sub-steps:

• Selecting (401) a code word,
• For each bit of said code word, executing in an iterative manner the following steps:

➢ Modifying (402) the value of said bit,➢ Decoding (404) the modified code word (403),

➢ Encoding (405) the result of the decoding (404),

➢ Calculating a distance between the result of the encoding (405) and the modified code word (403),

➢ Saving the calculated distance in a table (409),

- Executing (102) in an iterative manner the following steps:

• A step (103) of decoding said received code word,
• A step of testing stopping (104) the method,
• A step (106) of calculating information of global likelihood IM(i) of the decoded code word,
• A step (107) of comparing, from the second iteration (i=2), the information of global likelihood IM(i) calculated in the current iteration (i) with the information of global likelihood IM(i-1) calculated in the previous iteration (i-1),
• A step (109) of modifying the amplitude and sign of the information of local likelihood LLR of a bit of said received code word, the index of the selected bit corresponding to the index of said table (409) associated with the lowest distance in the table, among the non-selected indices in a previous iteration,
• From the second iteration (i=2), if the information of the global likelihood IM(i) calculated in the current iteration (i) is less than the information of the global likelihood IM(i-1) calculated in the previous iteration (i-1), a step (108) of reinitialising the information of the local likelihood of the bit of said received code word modified in the previous iteration.

2. Iterative method for decoding according to claim 1 in which said decoding step (103) is iterative and the stopping test (104) is a test on the number of iterations of the decoding step (103).

3. Iterative method for decoding according to claim 1 in which the stopping test (104) is a test of convergence of the decoding step (103).

4. Iterative method for decoding according to claim 3 in which the test of convergence comprises the detection of an error in the result of the decoding step (103) by application of an error-detecting code (CRC).

5. Iterative method for decoding according to claim 3 in which the test of convergence comprises the comparison of the information of the global likelihood IM(i) with a predetermined threshold value.

6. Iterative method for decoding according to one of the previous claims in which the information of global likelihood IM(i) is mutual information.

7. Iterative method for decoding according to one of claims 1 to 5 in which the information of the global likelihood IM(i) is equal to the inverse of the Euclidean distance between the decoded then re-encoded code word and the received code word.

8. Iterative method for decoding according to one of the previous claims in which said subset of the bits of the received code word is equal to the entirety of the bits of the received code word or to a subset constituted of bits of which the local likelihood LLR presents an absolute value less than a predetermined threshold.

9. Iterative method for decoding according to one of the previous claims in which the correction code is a turbo code or a LDPC code.

10. Computer program comprising instructions for executing the iterative method for decoding according to any one of claims 1 to 9, when the program is executed by a processor.

11. Recording support readable by a processor on which is recorded a program comprising instructions for executing the iterative method for decoding according to any one of claims 1 to 9, when the program is executed by a processor.

12. Device comprising means adapted to execute the steps of the method according to one of claims 1 to 9.

FIG.1

FIG.2

**101**

Analyse du spectre
des mots de code

**110**

**109**

iti+1

**102**

**108**

oui

IM(i)
>
IM(i-1)

non

**107**

Décodeur
itératif

**103**

IM(i)

non

Test
d'arrêt

**104**

**106**

**111**

oui

**105**

FIG.3

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **M. OBERG ; P. SIEGEL.** Application of distance spectrum analysis to turbo code performance improvement. *Proc. 35th Annu. Conf. Commun, Control and Computing,* Septembre 1997, 701-710
- **Y. OULD-CHEIKH-MOUHAMEDOU.** A Method for Lowering Turbo Code Error Flare using Correction Impulses and Repeated Decoding. *6th international ITG-Conference on Source and Channel Coding (Turbocoding),* 2006
- **C. BERROU ; S. VATON.** Computing the minimum distance of linear codes by the error impulse method. *proc. of IEEE ISIT,* 2002
- **S. CROZIER et al.** Estimating the Minimum Distance of Turbo-Codes using double and Triple Impulse Methods. *IEEE Comm. Letters,* 2005
- **R. GARELLO ; A. VILA.** The All-zero iterative decoding algorithm for turbo code minimum distance computation. *proc of IEEE ICC,* 2004
- **J. HAGENAUER.** The Exit Chart - Introduction to Extrinsic Information Transfer in iterative Processing. *Proc. of 12th Europ. Signal. Proc. (EUSIPCO),* 2004
- **E. PAPAGIANNIS et al.** Approaching the ML performance with iterative decoding. *Int. Zurich Seminar on Communications,* 18 Février 2004